# EUROPEAN PATENT APPLICATION

(11) **EP 1 587 150 A2**
(43) Date of publication of application: **19.10.2005**
(21) Application number: 04030979.1
(22) Date of filing: 29.12.2004
(51) Int. Cl.: H01L 33/00

(54) **Silicon light emitting device and method of manufacturing the same**

(30) Priority: 12.04.2004 KR 2004024917
(71) Applicant: ELECTRONICS AND TELECOMMUNICATIONS RESEARCH INSTITUTE, Daejon-Shi (KR)
(72) Inventor: Park, Nae Man, Daejeon 305-345 (KR); Kim, Tae Youb, Seoul 122-842 (KR); Kim, Kyung Hyun, Daejeon 305-800 (KR); Sung, Gun Yong, Daejeon 305-755 (KR)
(74) Representative: Betten & Resch

(57) **Abstract**

Provided is to a silicon light emitting device and the method of manufacturing the same which comprises a silicon nano-dot light emitting layer; electrodes to apply voltage level to the silicon nano-dot light emitting layer; a SiCN on at least one region of the upper or lower side of the silicon nano-dot light emitting layer film to improve a light emitting efficiency.

## Description

### CROSS-REFERENCE TO RELATED APPLICATIONS

This application claims the benefit of Korean Patent Application No. 2004-24917, filed April 12, 2004, in the Korean Intellectual Property Office, the disclosure of which is incorporated herein by reference.

### BACKGROUND

### 1. Field of the Invention

The present invention relates to a silicon light emitting device and a method of manufacturing the same, and more particularly, to a silicon light emitting device in which a SiCN film is positioned on at least one side of an upper side and lower side of a silicon light emitting layer in order to improve a light emitting efficiency.

### 2. Discussion of Related Art

The light emitting device using the silicon nano-dot overcomes the limitation of the silicon semiconductor which has a low light emitting efficiency due to an indirect bandgap.

However, a silicon oxide or silicon nitride thin film used for a matrix decreases an applicability of device, because they are dielectric materials. Generally, the dielectric material is not, so that the doping layer must be formed on the upper side of the dielectric material to improve charge mobility. However, the silicon oxide or silicon nitride thin film is structurally amorphous, so it is desirous that an amorphous doping layer is formed on those thin films for effective growth.

In this case, the emitted wavelength is adjusted by adjusting the size of the silicon nano-dot. A band gap energy on the upper side of the doping layer should be adjusted to inject effectively the charge into the light emitting layer. Furthermore, the upper doping layer should be transparent to emit the light effectively.

Because the amorphous doping layer based on these requirements has still not been developed, a mass production of the silicon light emitting device is difficult.

### SUMMARY OF THE INVENTION

Accordingly, it is an aspect of the present invention to provide a silicon light emitting device and method of the manufacturing the same in which the silicon carbon nitride film is positioned on at least one side of the upper side and lower side of the silicon light emitting layer to improve the emitting efficiency in the region of the near infrared ray, visible light and ultraviolet.

The foregoing and/or other aspects of the present invention is achieved by providing a silicon light emitting device comprising: a silicon nano-dot light emitting layer; electrodes to apply voltage level to the silicon nano-dot light emitting layer; and a SiCN film on at least one region of the upper and lower side of the silicon nano-dot light emitting layer, to improve a light emitting efficiency.

According to an aspect of the invention, the silicon nano-dot light emitting layer includes a crystalline or amorphous silicon quantum dot surrounded by a matrix of amorphous silicon oxide or silicon nitride.

According to an aspect of the invention, the thickness of the SiCN film is 0.1 to 4µm, the doping density is 10¹⁶ to 10¹⁹cm⁻³, band gap energy is 2.0eV to 4.0eV and transmissity is 60% to 99%.

The foregoing and/or still another aspect of the present invention are achieved by providing a method of manufacturing of a silicon light emitting device comprising, the silicon light emitting device comprising a silicon nano-dot light emitting layer; and electrodes to apply voltage level to the silicon light emitting layer; forming a SiCN film on at least one region of the upper and lower side of the silicon light emitting layer, to improve a light emitting efficiency.

According to an aspect of the invention, the SiCN film is formed by PECVD using the silane gas, methane gas, nitrogen or ammonia gas.

According to an aspect of the invention, the SiCN is formed at a temperature range of 100 to 600°C, and the growth pressure is in range of 0.1 to 10 Torr.

According to an aspect of the invention, the SiCN film is manufactured by the sputtering method using methane, nitrogen and ammonia gas, and formed using SiC or SiN as a target.

According to an aspect of the invention, the SiCN film is rapidly heat-treated at a temperature of 300 to 800°C from thirty minutes to five minutes to activate an impurity for acquiring the doping density in the range of 10¹⁶ to 10¹⁹ cm⁻³.

The foregoing and/or still another aspect of the present invention are achieved by providing a silicon light emitting device comprising: a substrate; a silicon nano-dot light emitting layer formed on a predetermined region of the upper side of the substrate; a SiCN film formed on at least one region of the upper side or lower side of the silicon nano-dot light emitting layer, to improve the light emitting efficiency; and a first electrode and a second electrode positioned to apply the voltage level to the silicon light emitting layer.

According to an aspect of the invention, the SiCN film is formed on the upper side of the silicon nano-dot light emitting layer; the first electrode formed on the silicon substrate at a lateral side of the silicon nano-dot light emitting layer, and the second electrode formed on a predetermined region of the upper side of the SiCN.

According to an aspect of the invention, the silicon light emitting device further comprises the SiCN film between the silicon nano-dot light emitting layer and the silicon substrate.

### BRIEF DESCRIPTION OF THE DRAWINGS

These and/or other aspects and advantages of the invention will become apparent and more readily appreciated from the following description of the preferred embodiments, taken in conjunction with the accompanying drawings of which:

FIG. 1 is a view of an band gap energy of the SiCN applied to the silicon light emitting device according to an embodiment of the present invention;

FIG. 2 is a sectional view of a silicon light emitting device according to the first embodiment of the present invention;

FIG. 3 is a sectional view of a silicon light emitting device according to the second embodiment of the present invention;

### DETAILED DESCRIPTION OF PREFERRED EMBODIMENTS

Hereinafter, preferable embodiments according to the present invention will be described in detail with reference to the accompanying drawings, wherein the preferred embodiments of the present invention is provided to be readily understood by those skilled in the art, so that variously other modifications are apparent and the present invention is not limited to the following embodiments disclosed herein. In the meantime, in the event of describing such as the phrase "one film is formed on the other film or the semiconductor substrate", the one film may be attached directly to the other film or the semiconductor substrate, or a third film may be interjacent between the one film and the semiconductor substrate. Furthermore, the thickness and size of each layer in the drawings are exaggerated for a convenience and clearness. The same sign of the drawings indicates a same component.

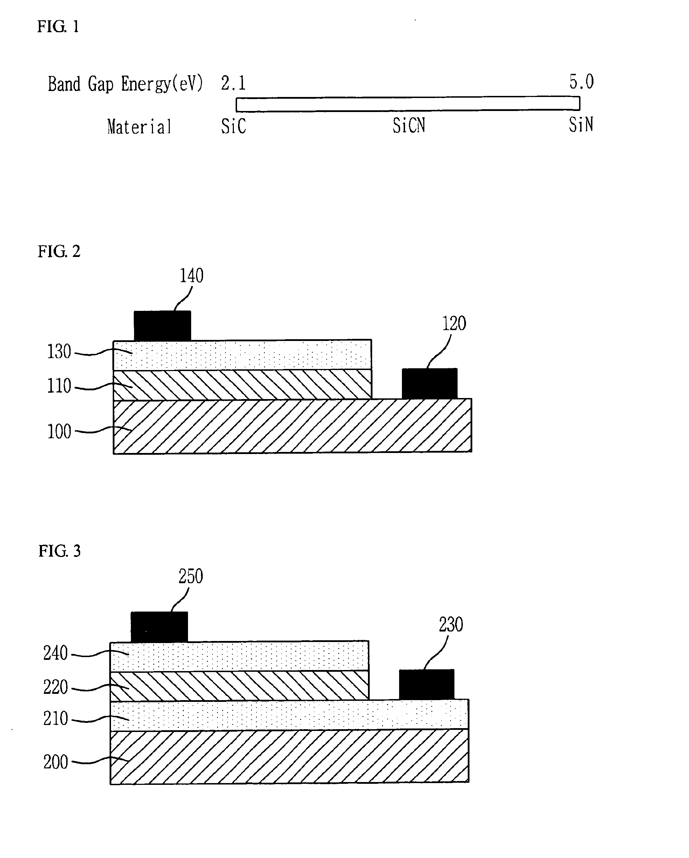

FIG. 1 is a view of the band gap energy of the SiCN applied to the silicon light emitting device according to the present invention.

As shown in FIG. 1, as for the SiCN film, the band gap energy is continuously changed based on the value of the X(0≤x≤1) in SiC_{X}N_{1-X}. The SiCN film is amorphous material.

Therefore, if the quantity of the carbon and nitrogen is adjusted in the process of manufacturing the amorphous SiCN film, the SiCN fim is manufactured from the range of 2.1eV (band gap energy of SiC) to 5.0eV (band gap energy of Si₃N₄).

FIG. 2 is a sectional view of a silicon light emitting device according to the first embodiment of the present invention;

As shown in FIG. 2, the silicon light emitting layer 110 is formed on a predetermined region of the upper side of the substrate 100, and the p-type electrode 120 is formed on a predetermined region of the substrate 100 in which the silicon nano-dot light emitting layer 110 dose not exist. Preferably, the substrate 100 is a p-type silicon substrate.

It is applicable without limitations if the substrate 100 is used for the supporting member of the light emitting device. Preferably, semiconductor substrate such as germanium and silicon, and compound semiconductor substrate such as SiGe, SiC, GaAs and InGaAs can be used for the substrate. In the case that the silicon nano-dot light emitting layer includes the silicon quantum dots, using the silicon substrate makes it possible to form the silicon nano-dot light emitting layer directly on the silicon substrate. Meanwhile, if other kinds of substrates except for the silicon substrate are used, the additional silicon layer is formed on the substrate, and on which the silicon nano-dot light emitting layer is formed.

The SiCN film 130 is formed on the upper side of the silicon nano-dot light emitting layer 110. Preferably, the SiCN film 130 is an n-type transparent doping layer, on which the n-type electrode 140 is formed. For the n-type doping, the phosphorous (P) dopant can be used, and for the p-type doping, the boron (B) dopant can be used. The desirable doping density of the amorphous SiCN film is about 10¹⁶ to 10¹⁹ cm⁻³, in this case, the band gap energy can be adjusted in the range of 2.0eV to 4.0eV, and the transimissity of the emitted light is within the range of 60%~99%.

In the silicon silicon nano-dot light emitting layer 110, the crystalline silicon structure is surrounded by the amorphous silicon oxide or amorphous silicon nitride matrix, and the amorphous silicon quantum dot is surrounded by the amorphous silicon oxide or silicon nitride matrix. And the silicon nano-dot light emitting layer 110 is formed with various methods. The wavelength of the emitted light can be adjusted according to systems or requirements. Single wavelength or several wavelengths can be acquired

The silicon nano-dot light emitting layer 110 can be formed by PECVD or sputtering method. Silane gas, nitric gas (nitrogen or ammonia gas) are used and then manufactures the silicon oxide or silicon nitride film and the crystalline silicon structure. A heat treatment process can be used for manufacturing the silicon structure.

Preferably, the positive-type electrode 120 is made of Ni/Au and the n-type electrode 140 is made of Ti/Al, and the position of the p-type electrode 120 and n-type 140 can be changed.

The SiCN film 130 is deposited by PECVD, the growth temperature is 100 to 600°C, and the growth pressure is 0.1 to 10 Torr. At this time, nitrogen or ammonia gas can be used addition to silane gas or methane gas, and the desirable thickness of the SiCN film 130 is 0.1 to 4µm.

On the other hand, the SiCN film 130 is manufactured by the sputter method, the growth temperature ranges from room temperature to 600°C, the growth pressure is 1 to 10 Torr. At this time, nitrogen or ammonia gas can be used and the silicon, silicon carbide (SiC) or silicon nitride (SiN) can be used for a target.

The SiCN film 130 is rapidly heat-treated at a temperature of 300 to 800 °C from thirty minutes to five minutes to activate an impurity for acquiring the doping density in the range of 10¹⁶ to 10¹⁹ cm⁻³.

FIG. 3 is a sectional view of a silicon light emitting device according to the second embodiment of the present invention. For explanative convenience, the explanation of the second embodiment would be described focusing on the differences with the first embodiment of the present invention.

As shown in FIG. 3, the first SiCN film 210 is formed on the upper side of the substrate (such as p-type silicon substrate), and the silicon light emitting layer 220 is formed on a predetermined region of the upper side of the SiCN film 210. The p-type electrode 230 is formed on a predetermined region of the first SiCN film 210 in which the silicon light emitting layer 220 does not exist.

Furthermore, the second SiCN film 240 is formed on upper side of the silicon nano-dot light emitting layer 220. The first SiCN film 210 is the p-type transparent doping layer, and the second SiCN film 240 is the n-type transparent doping layer. The n-type electrode 250 is formed on a predetermined region of the upper side of the second SiCN film 240.

Herein, the silicon nano-dot light emitting layer 220 and the first and second SiCN film 210, 240 were described on the first embodiment of the present invention, the explanation in detail would be omitted.

The first SiCN film 210 is the p-type transparent doping layer, and its thickness is 1 to 4µm, and its doping density can be adjusted in the range of 10¹⁶ to 10¹⁹ cm⁻³.

In FIG. 3, even though the first SiCN film 210 is positioned between the substrate 200 and the p-type electrode, it is obvious that the fist SiCN film 210 can be deposited only between the silicon nano-dot light emitting layer 220 and the substrate 200.

Though the preferred embodiment of the silicon light emitting device and the manufacturing method the same was described before, on which the present invention is not limited, and the various applications are possible within the range of the claims, and detailed description of the present invention and drawings, and those are included in the present invention.

For example, that the SiCN film is only deposited on lower side of the silicon nano-dot light emitting layer is not shown in FIG.2 and FIG. 3, however, it is obvious that the those applications are possible.

As described above, the present invention provides the silicon light emitting device and the method of manufacturing the same comprising the SiCN film as a transparent doping layer on at least one side of the upper side and lower side of the silicon nano-dot light emitting layer positioned between two electrodes, thereby the efficiency of the light emitting within the range of the near infrared ray, visible light and ultraviolet can be increased.

Although a few embodiments of the present invention have been shown and described, it would be appreciated by those skilled in the art that changes might be made in this embodiment without departing from the principles and spirit of the invention, the scope of which is defined in the claims and their equivalents.

## Claims

1. A silicon light emitting device comprising
a silicon nano-dot light emitting layer;
electrodes to apply voltage level to the silicon nano-dot light emitting layer;
a SiCN film on at least one region of the upper and lower side of the silicon nano-dot light emitting layer, to improve a light emitting efficiency.

2. The silicon light emitting device according to claim 1, wherein the silicon nano-dot light emitting layer includes a crystalline or amorphous silicon quantum dot surrounded by a matrix of amorphous silicon oxide or silicon nitride.

3. The silicon light emitting device according to claim 1 or 2, wherein the thickness of the SiCN film is 0.1 to 4µm.

4. The silicon light emitting device according to claim 1, 2 or 3 wherein the doping density of the SiCN film is 10¹⁶ to 10¹⁹ cm⁻³.

5. The silicon light emitting device according to one of claims 1 to 4, wherein the energy band gap of the SiCN film is 2.0eV to 4.0eV.

6. The silicon light emitting device according to one of claims 1 to 5, wherein the transmissity of SiCN film is in the range of 60% to 99%.

7. A method of manufacturing of a silicon light emitting device, the silicon light emitting device comprising a silicon nano-dot light emitting layer and electrodes to apply a voltage level to the silicon nano-dot light emitting layer, comprising
forming a SiCN film on at least one region of the upper and lower side of the silicon nano-dot light emitting layer, to improve a light emitting efficiency.

8. The method of the manufacturing of the silicon light emitting device according to claim 7, wherein the SiCN film is formed by PECVD using silane gas, methane gas, nitrogen or ammonia gas.

9. The method of the manufacturing of the silicon light emitting device according to claim 8, wherein the SiCN is formed at a temperature range of 100 to 600°C, and the growth pressure is in range of 0.1 to 10Torr.

10. The method of the manufacturing of the silicon light emitting device according to claim 7, 8 or 9, wherein the SiCN film is manufactured by a sputtering method using methane, nitrogen and ammonia gas, and formed using SiC or SiN as a target.

11. The method of the manufacturing of the silicon light emitting device according to claim 10, wherein the SiCN film is manufactured at the temperature range of 100 to 600°C, and the growth pressure is in range of 1 to 10Torr.

12. The method of the manufacturing of the silicon light emitting device according to one of claims 7 to 11, wherein the SiCN film is rapidly heat-treated at a temperature of 300 to 800°C from thirty minutes to five minutes to activate an impurity for acquiring the doping density in the range of 10¹⁶ to 10¹⁹ cm⁻³.

13. A silicon light emitting device comprising:
a substrate;
a silicon nano-dot light emitting layer formed on a predetermined region of the upper side of the substrate;
a SiCN film formed on at least one region of the upper side or lower side of the silicon nano-dot light emitting layer, to improve the light emitting efficiency; and
a first electrode and a second electrode positioned to apply the voltage level to the silicon nano-dot light emitting layer.

14. The silicon light emitting device according to claim 13, wherein the SiCN film is formed on the upper side of the silicon nano-dot light emitting layer; the first electrode is formed on the silicon substrate at a lateral side of the silicon nano-dot light emitting layer, and the second electrode is formed on a predetermined region of the upper side of the SiCN film.

15. The silicon light emitting device according to claim 14, further comprising the SiCN film between the silicon nano-dot light emitting layer and the silicon substrate.
